# EUROPEAN PATENT APPLICATION

(11) **EP 4 797 908 A1**
(43) Date of publication of application: **26.08.2026**
(21) Application number: 24812680.7
(22) Date of filing: 23.10.2024
(51) Int. Cl.: H10F 10/174, H10F 71/00

(54) **SOLAR CELL AND MANUFACTURING METHOD THEREFOR, AND ELECTRIC DEVICE**

(30) Priority: 04.09.2024 CN 202411241102
(71) Applicant: Yingkou Jinchen Machinery Co., Ltd., Yingkou, Liaoning 115000 (CN)
(72) Inventor: WANG, Kai, Yingkou, Liaoning 115000 (CN); TAO, Ke, Yingkou, Liaoning 115000 (CN); YAN, Baojie, Yingkou, Liaoning 115000 (CN); YANG, Baohai, Yingkou, Liaoning 115000 (CN); LI, Yisheng, Yingkou, Liaoning 115000 (CN)
(74) Representative: Herrero & Asociados, S.L.
(86) International application number: PCT/CN2024/126784
(87) International publication number: WO 2026/051163

(57) **Abstract**

The present application provides a solar cell, a method for manufacturing the solar cell, and an electric device. The solar cell includes: a substrate provided with a first surface and a second surface arranged opposite to the first surface, the first surface including first regions and second regions, which are alternately arranged; a tunnel oxide layer and a doped polysilicon layer arranged on the first regions in the first surface, the tunnel oxide layer being arranged between the first surface and the doped polysilicon layer; a first passivation layer including a first passivation sub-layer covering the doped polysilicon layer in the first regions and a second passivation sub-layer covering the second regions; and an intrinsic amorphous silicon layer and a doped amorphous silicon layer arranged on the second surface, the intrinsic amorphous silicon layer being arranged between the second surface and the doped amorphous silicon layer, a conductivity type of the doped polysilicon layer being different from a conductivity type of the doped amorphous silicon layer.

## Description

### CROSS-REFERENCE TO RELATED APPLICATIONS

This application is based upon and claims priority to Chinese Patent Application No. 202411241102.2 filed on September 4, 2024, the contents of which are incorporated herein by reference in its entirety.

### TECHNICAL FIELD

The present application includes, but is not limited to, a solar cell, a method for manufacturing a solar cell, and an electric device.

### BACKGROUND

A front side of a Tunnel Oxide Passivated Contact (TOPCon) cell is formed with a P-type doped polysilicon layer, resulting in a poor passivation effect and a poor contact characteristic. Thus, the photoelectric conversion efficiency of the TOPCon cell still has a certain room for improvement from the theoretical efficiency.

Therefore, improvement in the TOPCon cell is urgently needed, so as to improve the photoelectric conversion efficiency of the TOPCon cell.

### SUMMARY

In view of this, the present application provides a solar cell, a method for manufacturing a solar cell, and an electric device.

In a first aspect, the present application provides a solar cell. The solar cell includes: a substrate, in which the substrate is provided with a first surface and a second surface arranged opposite to the first surface, the first surface including first regions and second regions, the first regions and the second regions being alternately arranged; a tunnel oxide layer and a doped polysilicon layer which are arranged on the first regions in the first surface, in which the tunnel oxide layer is arranged between the first surface and the doped polysilicon layer; a first passivation layer, in which the first passivation layer includes a first passivation sub-layer covering the doped polysilicon layer in the first regions, and a second passivation sub-layer covering the second regions; and an intrinsic amorphous silicon layer and a doped amorphous silicon layer which are arranged on the second surface, in which the intrinsic amorphous silicon layer is arranged between the second surface and the doped amorphous silicon layer, in which a conductivity type of the doped polysilicon layer is different from a conductivity type of the doped amorphous silicon layer.

In some embodiments, the solar cell further includes: a first antireflection layer covering the first passivation layer; and first electrodes, in which the first electrodes penetrate through the first antireflection layer and the first passivation sub-layer and are in contact with the doped polysilicon layer.

In some embodiments, the solar cell further includes: a second passivation layer covering the doped amorphous silicon layer; a second antireflection layer covering the second passivation layer; and second electrodes, in which the second electrodes penetrate through the second antireflection layer and the second passivation layer and are in contact with the doped amorphous silicon layer.

In some embodiments, the substrate includes an N-type semiconductor substrate, the doped polysilicon layer includes an N-type doped polysilicon layer, and the doped amorphous silicon layer includes a P-type doped amorphous silicon layer.

In some embodiments, a thickness of the tunnel oxide layer ranges from 0.5 nm to 3 nm, and a thickness of the doped polysilicon layer ranges from 60 nm to 130 nm.

In some embodiments, a thickness of the intrinsic amorphous silicon layer ranges from 5 nm to 9 nm, and a thickness of the doped amorphous silicon layer ranges from 30 nm to 40 nm.

In a second aspect, the present application provides a method for manufacturing a solar cell, which includes the following operations. A substrate is provided, in which the substrate is provided with a first surface and a second surface arranged opposite to the first surface, the first surface including first regions and second regions, the first regions and the second regions being alternately arranged. A tunnel oxide layer and a doped polysilicon layer are sequentially formed on the first surface. The doped polysilicon layer and the tunnel oxide layer are patterned to expose the second regions in the first surface. An intrinsic amorphous silicon layer and a doped amorphous silicon layer are sequentially formed on the second surface, in which a conductivity type of the doped polysilicon layer is different from a conductivity type of the doped amorphous silicon layer. A first passivation layer is formed on the first surface, in which the first passivation layer includes a first passivation sub-layer covering the doped polysilicon layer in the first regions, and a second passivation sub-layer covering the second regions.

In some embodiment, the operation that the intrinsic amorphous silicon layer and the doped amorphous silicon layer are sequentially formed on the second surface includes the following operations. A silicon source gas is introduced and reacted through a plasma enhanced chemical vapor deposition process to form the intrinsic amorphous silicon layer. A silicon source gas and a gas containing doped elements are introduced and reacted to form the doped amorphous silicon layer.

In some embodiments, a temperature in the plasma enhanced chemical vapor deposition process ranges from 200 °C to 400 °C.

In some embodiments, the method further includes the following operations. A second passivation layer is formed on the second surface, in which the second passivation layer covers the doped amorphous silicon layer. A first antireflection layer is formed on the first surface, in which the first antireflection layer covers the first passivation layer. A second antireflection layer is formed on the second surface, in which the second antireflection layer covers the second passivation layer.

In some embodiments, the method further includes the following operations. First electrodes are formed, in which the first electrodes penetrate through the first antireflection layer and the first passivation sub-layer and are in contact with the doped polysilicon layer. Second electrode are formed, in which the second electrodes penetrate through the second antireflection layer and the second passivation layer and are in contact with the doped amorphous silicon layer.

In a third aspect, the present application provides an electric device. The electric device includes the solar cell as described in the first aspect of the present application.

### BRIEF DESCRIPTION OF THE DRAWINGS

FIG. 1 is a sectional view of a tunnel oxide passivated contact cell according to some examples;
FIG. 2 is a flowchart for manufacturing a tunnel oxide passivated contact cell according to some examples;
FIG. 3 is a sectional view of a heterojunction with intrinsic thin-film cell according to some examples;
FIG. 4 is a schematic flowchart of a method for manufacturing a solar cell according to the present application;
FIG. 5 is a sectional view of a solar cell according to the present application;
FIG. 6 is a flowchart for manufacturing a solar cell according to the present application; and
FIG. 7 is a schematic view of an electric device according to the present application.

The figures include: 100-TOPCon cell; 110-substrate; 111-first surface; 112-second surface; 120-tunnel oxide layer; 131-N-type doped polysilicon layer; 132-P-type doped polysilicon layer; 140-passivation layer; 151-first antireflection layer; 152-second antireflection layer; 161-first electrode; 162-second electrode; 300-HJT cell; 310-substrate; 311-first surface; 312-second surface; 321-first intrinsic amorphous silicon layer; 322-second intrinsic amorphous silicon layer; 331-P-type doped amorphous silicon layer; 332-N-type doped amorphous silicon layer; 341-first transparent conductive layer; 342-second transparent conductive layer; 351-first electrode; 352-second electrode; 500-solar cell; 510-substrate; 511-first surface; 512-second surface; 511a-first region; 511b-second region; 520-tunnel oxide layer; 530-doped polysilicon layer; 540-first passivation layer; 541-first passivation sub-layer; 542-second passivation sub-layer; 550-intrinsic amorphous silicon layer; 560-doped amorphous silicon layer; 570-second passivation layer; 581-first antireflection layer; 582-second antireflection layer; 591-first electrode; 592-second electrode; 700-electric device.

### DETAILED DESCRIPTION

The technical solutions in the implementations of the present application are clearly and completely described below with reference to the implementations in the present application and the accompanying drawings. It is apparent that the implementations described are merely some rather than all of the implementations of the present application. All other implementations obtained by a person of ordinary skill in the art based on the implementations of the present application without creative efforts shall fall within the protection scope of the present application.

In the following description, numerous specific details are set forth in order to provide a more thorough understanding of the present application. However, it will be apparent to those skilled in the art that the present application can be implemented without one or more of these details. In other examples, in order to avoid confusion with the present application, some technical features known in the art are not described. That is, not all of the features of the actual embodiments are described here, and the well-known functions and structures are not described in detail.

In the accompanying drawings, the sizes and relative size of layers, regions, and elements may be exaggerated for clarity. The same reference numeral denotes the same element throughout the present application.

It should be understood that, when an element or layer is described as being "on", "adjacent to", "connected to" or "coupled to" another element or layer, it can be directly on, adjacent to, connected to, or coupled to the other element or layer, or there can be an intermediate element or layer. In contrast, when an element is described as being "directly on", "directly adjacent to", "directly connected to" or "directly coupled to" another element or layer, there is no intermediate element or layer. It should be understood that although the terms "first", "second", "third" and so on may be used to describe various elements, components, regions, layers, and/or portions, these elements, components, regions, layers, and/or portions should not be limited by these terms. These terms are used merely to distinguish an element, component, region, layer, or portion from another element, component, region, layer, or portion. Therefore, a first element, component, region, layer, or portion discussed below may be described as a second element, component, region, layer, or portion without departing from the teachings of the present application. When the second element, component, region, layer or portion is discussed, it does not mean that the first element, component, region, layer or portion is necessarily present in the present application.

Spatial relation terms such as "below", "under", "lower", "beneath", "above", and "on" may be used herein for convenience of description to describe a relationship between an element or feature and another element or feature illustrated in the figures. It should be understood that, in addition to the orientations shown in the figures, the spatial relation terms are intended to include different orientations of devices in use and operation. For example, if the devices in the figures are turned over, then the element or feature described as "under" or "beneath" or "below" another element or feature would then be oriented as "above" the other element or feature. Therefore, the exemplary terms "under" and "below" may include both orientations of above and below. The device may be otherwise oriented (rotated by 90 degrees or in other orientations) and the spatial descriptions used herein may be interpreted accordingly.

Terms used herein are for the purpose of describing specific embodiments only and are not intended to limit the present application. As used herein, "a/an", "one", and "the" in singular forms are also intended to include a plural form unless the context clearly indicates other forms. It should also be understood that the terms "consist" and/or "include" when used in the description, determine the presence of the features, integers, steps, operations, elements, and/or components, but do not exclude the presence or addition of one or more other features, integers, steps, operations, elements, components, and/or groups. As used herein, the term "and/or" includes any and all combinations of the related listed items.

In order to thoroughly understand the present application, detailed steps and detailed structures will be proposed in the following description, so as to explain the technical solutions of the present application. The preferred embodiments of the present application are described in detail below, however, the present application may also include other implementations in addition to these detailed descriptions.

In the field of photovoltaic technology, the rapid rise of N-type photovoltaic technology has become the focus of attention at present. With the continuous optimization of the N-type photovoltaic technology, an era of low carbon emission and high efficiency is coming. Traditional P-type photovoltaic technology is gradually eliminated due to limitations of efficiency and manufacturing procedure, which has promoted the industry to more advanced technologies. Thus, the penetration rate of N-type products with higher efficiency is rapidly increasing.

The advantage of the TOPCon cell technology is that the TOPCon cell and the Passivated Emitter and Rear Cell (PERC) are both made through a high-temperature process and have higher process compatibility. The TOPCon cell technology is preferred by traditional cell manufacturers, and may improve the conversion efficiency of photovoltaic cells more effectively. Taking M10 as an example, currently, the average efficiency of a single-sided TOPCon cell in the industry has reached 24.9%, and the highest conversion efficiency of the TOPCon cell in the laboratory has reached 26.1%. However, there is still a lot of room for improvement from the theoretical efficiency of the silicon cell. Moreover, according to calculations by an authoritative testing organization ISFH, the theoretical limit efficiency of the TOPCon cell is 28.7%, and thus there is still a lot of room for improvement in the future.

Before introducing the present application, various directions that may be referred to in the following description will be described. A first direction (i.e., X direction) and a second direction (i.e., Y direction) that intersect each other are defined in a plane parallel to the substrate, and a direction perpendicular to the substrate is defined as a third direction (i.e., Z direction). In some embodiments, the X direction and the Y direction may be perpendicular to each other, so that the X direction, the Y direction, and the Z direction are perpendicular to each other in pairs.

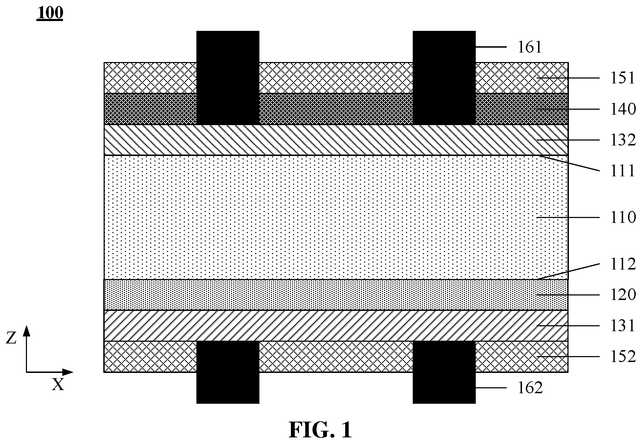

With reference to FIG. 1, FIG. 1 is a sectional view of a Tunnel Oxide Passivated Contact (TOPCon) cell according to some examples. As shown in FIG. 1, the TOPCon cell 100 includes: a substrate 110, the substrate 110 being provided with a first surface 111 and a second surface 112 arranged opposite to the first surface; a P-type doped polysilicon layer 132, a passivation layer 140 and a first antireflection layer 151, which are sequentially formed on the first surface 111; a plurality of first electrodes 161 which sequentially penetrate through the first antireflection layer 151 and the passivation layer 140 and are in contact with the P-type doped polysilicon layer 132; a tunnel oxide layer 120, an N-type doped polysilicon layer 131 and a second antireflection layer 152, which are sequentially formed on the second surface 112; and a plurality of second electrodes 162 which penetrate through the second antireflection layer 152 and are in contact with the N-type doped polysilicon layer 131. The TOPCon cell 100 includes, in the Z direction, the second antireflection layer 152, the N-type doped polysilicon layer 131, the tunnel oxide layer 120, the substrate 110, the P-type doped polysilicon layer 132, the passivation layer 140 and the first antireflection layer 151, which are sequentially stacked on one another.

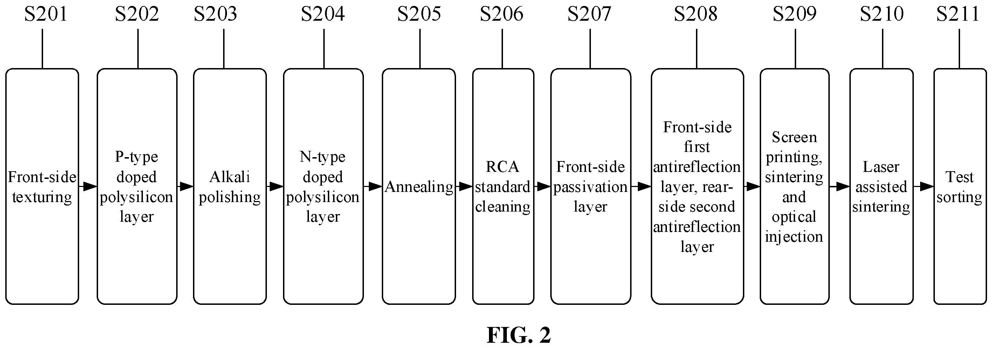

With reference to FIG. 2, FIG. 2 is a flowchart for manufacturing a tunnel oxide passivated contact cell according to some examples. As shown in FIG. 2, in operation S201, front-side texturing is performed, that is, the front side of the substrate is subjected to surface treatment to form a textured structure.

In operation S202, a P-type doped polysilicon layer is formed, that is, a boron-doped polysilicon layer is formed on the front side of the substrate through a boron diffusion process, so that the boron-doped polysilicon layer may be served as a P-type doped polysilicon layer.

At present, the boron diffusion process includes the following operations. BCl₃ is introduced into a quartz tube and is chemically reacted with O₂ to generate B₂O₃ (as shown in Equation 1). N₂ is introduced so that B₂O₃ is distributed on the surface of the substrate (for example, a silicon wafer), and B₂O₃ is then chemically reacted with the substrate (for example, a silicon wafer) to complete the boron diffusion process (as shown in Equation 2), so as to prepare a PN junction.

4BCl₃ + 3O₂ → 2B₂O₃ + 6Cl₂ (Equation 1)

2B₂O₃ + 3Si → 4B + 3SiO₂ (Equation 2)

Since the solid solubility of boron in silicon is less than that of SiO₂, it is necessary to control the high temperature and high flow conditions in the deposition process, so as to complete doping of boron. Since the reaction temperature in the boron diffusion process is relatively high, the service life of the furnace tube is shortened, and the production cost is relatively high. Moreover, B₂O₃ formed in the reaction process has adhesiveness and will be adhered to the surface of the furnace tube, resulting in different stresses in the furnace tube, so that there is a risk of breakage after long-term use, which further increases the production cost. As can be known above, formation of the P-type doped polysilicon layer in the TOPCon cell needs to be performed under the high temperature and high flow conditions, and the temperature in the boron doping process needs to be greater than 900 °C, resulting in higher equipment loss and higher usage cost.

In operation S203, alkali polishing is performed, that is, the rear side of the substrate is subjected to surface treatment to remove a diffusion layer (for example, Boro-silicate Glass (BSG)) formed on the rear side and the periphery of the substrate in the diffusion process in the previous operation.

In operation S204, an N-type doped polysilicon layer is formed, that is, a tunnel oxide layer and an N-type doped polysilicon layer are formed on the rear side of the substrate.

In operation S205, annealing is performed, that is, the N-type doped polysilicon layer is annealed.

In operation S206, RCA standard cleaning is performed, that is, Phospho-silicate Glass (PSG) formed on the front side and the periphery of the substrate in the previous operation is removed.

In operation S207, a front-side passivation layer is formed, that is, a passivation layer covering the P-type doped polysilicon layer is formed on the front side of the substrate. A material of the passivation layer may be, for example, alumina.

In operation S208, a front-side first antireflection layer and a rear-side second antireflection layer are formed, that is, a first antireflection layer covering the passivation layer is formed on the front side of the substrate, and a second antireflection layer covering the N-type doped polysilicon layer is formed on the rear side of the substrate. A material of each of the first antireflection layer and the second antireflection layer may be, for example, silicon nitride.

In operation S209, screen printing, sintering and optical injection are performed, that is, first electrodes are formed on the front side of the substrate, and second electrodes are formed on the rear side of the substrate.

In operation S210, laser assisted sintering is performed, that is, a good ohmic contact is formed by high temperature sintering.

In operation S211, test sorting is performed, that is, cells with different conversion efficiencies are graded.

To sum up, in the process of forming the TOPCon cell, firstly, the front side of the substrate is textured and cleaned to from a textured structure, and then BCl₃ is introduced to perform PN junction doping through a thermal diffusion process (i.e., a P-type doped polysilicon layer is formed on the front side of the substrate), and then the rear side of the substrate is polished, and a tunnel passivation layer is deposited on the rear side of the substrate (i.e., a tunnel oxide layer and an N-type doped polysilicon layer are formed on the rear side of the substrate). After cleaning, an alumina layer is deposited on the front side of the substrate for passivation, and a silicon nitride layer is deposited on each of the front side and rear side of the substrate for passivation and light absorption, and then printing and sintering, and current conduction are performed.

In the above TOPCon cell, a boron-doped polysilicon layer is formed on the front side of the substrate, so that the equipment loss and the usage cost of forming the boron-doped polysilicon layer are high, and the passivation effect of the boron-doped polysilicon layer is poor, auger recombination on the front side is serious, and contact characteristics are poor, which result in low photoelectric conversion efficiency of the TOPCon cell.

Therefore, improvement in the TOPCon cell is urgently needed, so as to improve the passivation effect and the contact characteristics, reduce the equipment loss and the usage cost, thereby improving the photoelectric conversion efficiency of the solar cell.

The conversion efficiency of a Heterojunction with Intrinsic Thin-film (HJT) cell may reach 25.3%, which is high. However, due to the high cost of targets, slurries, equipment, etc., the cost performance of the HJT cell is low, and mass production of HJT cell has not been achieved.

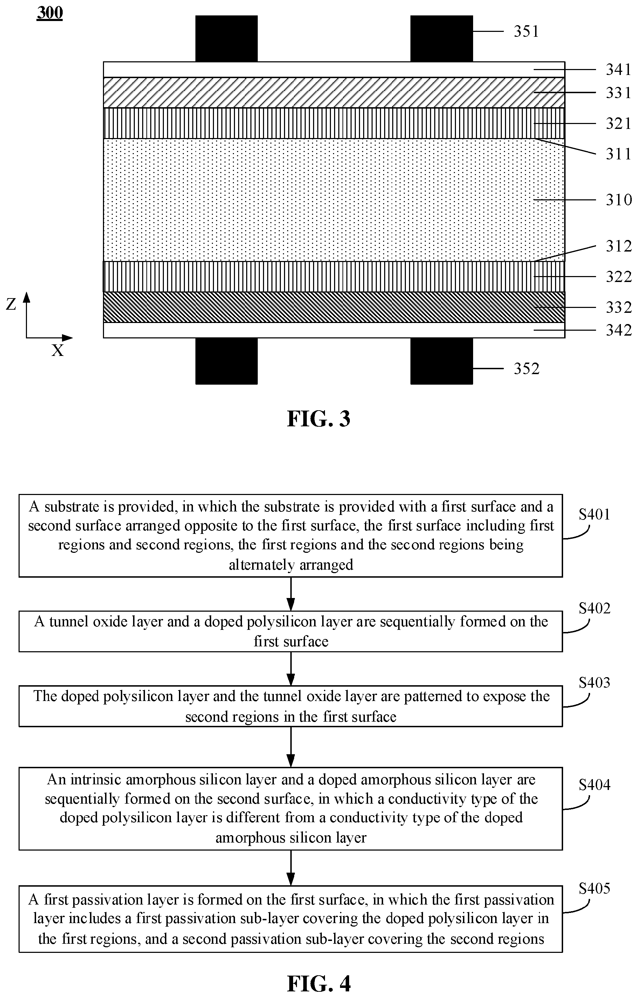

With reference to FIG. 3, FIG. 3 is a sectional view of a Heterojunction with Intrinsic Thin-film (HJT) cell according to some examples. As shown in FIG. 3, the HJT cell 300 includes: a substrate 310, in which the substrate 310 is provided with a first surface 311 and a second surface 312 arranged opposite to the first surface; a first intrinsic amorphous silicon layer 321, a P-type doped amorphous silicon layer 331 and a first transparent conductive layer 341 which are sequentially arranged on the first surface 311; a plurality of first electrodes 351 in contact with the first transparent conductive layer 341; a second intrinsic amorphous silicon layer 322, an N-type doped amorphous silicon layer 332 and a second transparent conductive layer 342 which are sequentially arranged on the second surface 312; and a plurality of second electrodes 352 in contact with the second transparent conductive layer 342. The HJT cell 300 includes, in the Z direction, a second transparent conductive layer 342, an N-type doped amorphous silicon layer 332, a second intrinsic amorphous silicon layer 322, a substrate 310, a first intrinsic amorphous silicon layer 321, a P-type doped amorphous silicon layer 331 and a first transparent conductive layer 341, which are sequentially stacked on one another.

For the TOPCon cell, the equipment loss and the usage cost are relatively high, the poor passivation effect and contact characteristics of the P-type doped polysilicon layer results in low photoelectric conversion efficiency of the cell; and for the HJT cell, the production cost is relatively high. Based on the above disadvantages, the present application provides a new solar cell, in which a tunnel oxide layer, an N-type doped polysilicon layer and a first passivation layer are formed on a front side of a substrate, and an intrinsic amorphous silicon layer and a P-type amorphous silicon layer are formed on a rear side of the substrate, so that the new solar cell may be upgraded on the basis of an original production line of the TOPCon cell, and thus the production cost is relatively low, and the conversion efficiency of the solar cell may be effectively improved.

With reference to FIG. 4, FIG. 4 is a schematic flowchart of a method for manufacturing a solar cell according to the present application. As shown in FIG. 4, the present application provides a method for manufacturing a solar cell, which includes the following operations.

In operation S401, a substrate is provided, in which the substrate is provided with a first surface and a second surface arranged opposite to the first surface, the first surface including first regions and second regions, the first regions and the second regions being alternately arranged.

In operation S402, a tunnel oxide layer and a doped polysilicon layer are sequentially formed on the first surface.

In operation S403, the doped polysilicon layer and the tunnel oxide layer are patterned to expose the second regions in the first surface.

In operation S404, an intrinsic amorphous silicon layer and a doped amorphous silicon layer are sequentially formed on the second surface, in which a conductivity type of the doped polysilicon layer is different from a conductivity type of the doped amorphous silicon layer.

In operation S405, a first passivation layer is formed on the first surface, in which the first passivation layer includes a first passivation sub-layer covering the doped polysilicon layer in the first regions, and a second passivation sub-layer covering the second regions.

Compared to the TOPCon cell and the HJT cell, in the present application, a tunnel oxide layer and a doped polysilicon layer are provided on the first regions in the first surface of the substrate (i.e., the front side of the substrate), a first passivation sub-layer is provided on the doped polysilicon layer, and a second passivation sub-layer is provided on the second regions in the first surface of the substrate, the first passivation sub-layer and the second passivation sub-layer collectively forming a first passivation layer; and an intrinsic amorphous silicon layer and a doped amorphous silicon layer are provided on the second surface of the substrate (i.e., the rear side of the substrate). Thus, in the solar cell provided in the present application, the intrinsic amorphous silicon layer on the rear side of the cell has high passivation characteristics, and the doped amorphous silicon layer has easy doping characteristics, so that the recombination on the rear side of the cell may be reduced. A patterned tunnel oxide layer and a patterned doped polysilicon layer are adopted on the front side of the cell, and a first passivation layer covering the first regions and the second regions in the first surface is formed on the front side of the cell, so that the contact passivation characteristics of the front side of the cell may be improved, thereby improving the photoelectric conversion efficiency of the solar cell.

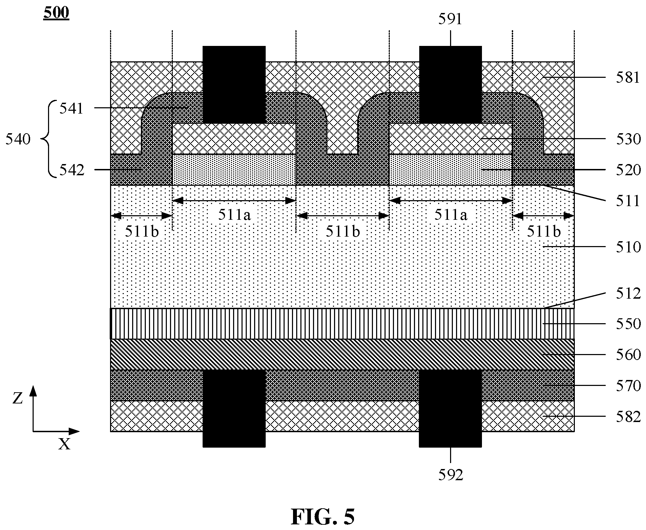

With reference to FIG. 5, FIG. 5 is a sectional view of a solar cell according to the present application. Hereinafter, a method for manufacturing a solar cell provided in the present application will be described in detail with reference to FIG. 4 and FIG. 5.

In the present application, in operation S401, a substrate is provided, in which the substrate is provided with a first surface and a second surface arranged opposite to the first surface, the first surface including first regions and second regions, the first regions and the second regions being alternately arranged.

As shown in FIG. 5, the substrate 510 is provided with, in its thickness direction (i.e., the Z direction), a first surface 511 and a second surface 512 arranged opposite to the first surface. The first surface 511 may also be referred to as the front side of the substrate 510, and the second surface 512 may also be referred to as the rear side of the substrate 510.

Here, the first surface 511 of the substrate 510 may be divided into first regions 511a and second regions 511b, the first regions and the second regions being alternately arranged in the X direction. The first regions 511a and the second regions 511b belong to a part of the first surface 511. The difference between the first region 511a and the second region 511b is that a film layer structure subsequently formed on the surface of the first region is different from a film layer structure subsequently formed on the surface of the second region, and an electrode will be subsequently formed in a position corresponding to the first region 511a, while no electrode will be subsequently formed in a position corresponding to the second region 511b. In other words, the first region 511a in the first surface 511 may also be referred to as an electrode contact region, and the second region 511b in the first surface 511 may also be referred to as a non-electrode contact region. In the present application, a ratio of an area of the first region 511a (or the second region 511b) to an area of the first surface 511 is not particularly limited, which may be flexibly selected according to actual situations.

In some embodiments, a material of the substrate 510 may include a semiconductor material, such as silicon.

In some embodiments, the substrate 510 may include an N-type semiconductor substrate or a P-type semiconductor substrate. In an embodiment of the present application, the substrate 510 may be an N-type silicon substrate.

In the present application, in operation S402, a tunnel oxide layer and a doped polysilicon layer are sequentially formed on the first surface.

As shown in FIG. 5, a tunnel oxide layer 520 and a doped polysilicon layer 530 are sequentially formed on the first surface 511 of the substrate 510. FIG. 5 illustrates a sectional view after patterning the doped polysilicon layer 530 and the tunnel oxide layer 520. It should be noted that before patterning process is performed, the tunnel oxide layer 520 covers both the first regions 511a and the second regions 511b in the first surface 511, and the doped polysilicon layer 530 covers the tunnel oxide layer 520. That is, in this case, the doped polysilicon layer 530 also covers both the tunnel oxide layer 520 arranged on the first regions 511a and the second regions 511b in the first surface 511. The tunnel oxide layer 520 is arranged between the first surface 511 of the substrate 510 and the doped polysilicon layer 530.

In some embodiments, a material of the tunnel oxide layer 520 may include silicon oxide.

In some embodiments, the doped polysilicon layer 530 may include an N-type doped polysilicon layer or a P-type doped polysilicon layer. In an embodiment of the present application, the doped polysilicon layer 530 is an N-type doped polysilicon layer (N-Poly).

In some embodiments, a process of forming the tunnel oxide layer 520 and the doped polysilicon layer 530 may include a Plasma Enhanced Chemical Vapor Deposition (PECVD) process, or a Low Pressure Chemical Vapor Deposition (LPCVD) process.

In some embodiments, a protective layer may also be formed on the doped polysilicon layer 530. Here, a thickness of the protective layer may range from 3 nm to 8 nm.

In some embodiments, a thickness of the tunnel oxide layer 520 ranges from 0.5 nm to 3 nm. Exemplarily, the thickness of the tunnel oxide layer 520 may be, for example, 0.5 nm, 1 nm, 1.5 nm, 2 nm, 2.5 nm or 3 nm. By defining the thickness of the tunnel oxide layer 520, the surface passivation effect may be improved.

In some embodiments, a thickness of the N-type doped polysilicon layer ranges from 60 nm to 130 nm. Exemplarily, the thickness of the N-type doped polysilicon layer may be, for example, 60 nm, 70 nm, 80 nm, 90 nm, 100 nm, 110 nm, 120 nm or 130 nm. By defining the thickness of the N-type doped polysilicon layer, the field passivation effect may be improved, and the parasitic absorption on the front side may be reduced.

In the present application, in operation S403, the doped polysilicon layer and the tunnel oxide layer are patterned to expose the second regions in the first surface.

As shown in FIG. 5, the doped polysilicon layer 530 and the tunnel oxide layer 520 are patterned, so as to remove the doped polysilicon layer 530 and the tunnel oxide layer 520 covering the second regions 511b in the first surface 511 and expose the second regions 511b in the first surface 511, in which the doped polysilicon layer 530 and the tunnel oxide layer 520 covering the first regions 511a in the first surface 511 are retained.

Here, in the present application, the specific process of patterning the doped polysilicon layer and the tunnel oxide layer is not particularly limited, as long as the doped polysilicon layer and the tunnel oxide layer covering the second regions may be removed, and the doped polysilicon layer and the tunnel oxide layer covering the first regions may be retained. Exemplarily, the patterning process may be, for example, a laser processing, etching slurry, a chemical method, or the like.

In the present application, a tunnel oxide layer and a doped polysilicon layer are provided on the first regions in the first surface of the substrate, so that the optical loss may be reduced. Moreover, a first passivation sub-layer is formed on the first regions, a second passivation sub-layer is provided on the second regions in the first surface of the substrate, the first region is a contact region of the first electrode, and the second region is a non-contact region of the first electrode, so that the passivation effect may be further improved.

In the present application, in operation S404, an intrinsic amorphous silicon layer and a doped amorphous silicon layer are sequentially formed on the second surface, in which a conductivity type of the doped polysilicon layer is different from a conductivity type of the doped amorphous silicon layer.

As shown in FIG. 5, an intrinsic amorphous silicon layer 550 and a doped amorphous silicon layer 560 are sequentially formed on the second surface 512 of the substrate 510. A conductivity type of the doped polysilicon layer 530 being different from a conductivity type of the doped amorphous silicon layer 560 may include: when the doped polysilicon layer 530 is an N-type doped polysilicon layer, the doped amorphous silicon layer 560 is a P-type doped amorphous silicon layer; and when the doped polysilicon layer 530 is a P-type doped polysilicon layer, the doped amorphous silicon layer 560 is an N-type doped amorphous silicon layer.

Here, the intrinsic amorphous silicon layer 550 may include a hydrogenated intrinsic amorphous silicon layer, which may be denoted as i: Si: H. In an embodiment of the present application, the intrinsic amorphous silicon layer 550 is a hydrogenated intrinsic amorphous silicon layer (i: Si: H).

Here, the doped amorphous silicon layer 560 may include a doped amorphous silicon layer or a doped microcrystalline silicon layer. The doped amorphous silicon layer may include a hydrogenated doped amorphous silicon layer, which may be denoted as α: Si: H. The doped microcrystalline silicon layer may also include a hydrogenated doped microcrystalline silicon layer, which may be denoted as µ: Si: H.

In some embodiments, the doped amorphous silicon layer 560 may include an N-type doped amorphous silicon layer or a P-type doped amorphous silicon layer. The doped microcrystalline silicon layer may include an N-type doped microcrystalline silicon layer or a P-type doped microcrystalline silicon layer, in which the P-type doped microcrystalline silicon layer may be denoted as P-µ: Si: H. In an embodiment of the present application, the doped amorphous silicon layer 560 is a P-type doped microcrystalline silicon layer (P-µ: Si: H).

In some embodiments, the process of forming the intrinsic amorphous silicon layer 550 and the doped amorphous silicon layer 560 may include a PECVD process.

In some embodiments, a thickness of the intrinsic amorphous silicon layer 550 ranges from 5 nm to 9 nm. Exemplarily, the thickness of the intrinsic amorphous silicon layer 550 may be, for example, 5 nm, 6 nm, 7 nm, 8 nm or 9 nm.

In some embodiments, a thickness of the P-type doped amorphous silicon layer ranges from 30 nm to 40 nm. Exemplarily, the thickness of the P-type doped amorphous silicon layer may be, for example, 30 nm, 32 nm, 34 nm, 36 nm, 38 nm or 40 nm.

In some embodiments, the operation S404 includes the following operations. A silicon source gas is introduced and reacted to form the intrinsic amorphous silicon layer 550, through a PECVD process. A silicon source gas and a gas containing doped elements are introduced and reacted to form the doped amorphous silicon layer 560.

Here, a PN junction may be prepared by ionizing SiH₄ and B₂H₆ through the PECVD process, in which the substance participating in the chemical reaction is gas. As shown in Equation 3 and Equation 4, SiH₄ is first used as the silicon source gas, and SiH₄ and H₂ are ionized, so as to deposit and form the intrinsic amorphous silicon layer on the second surface of the substrate. As shown in Equation 3, Equation 4 and Equation 5, then, SiH₄ is used as the silicon source gas and B₂H₆ is used as the gas containing doped elements, and SiH₄, B₂H₆ and H₂ are ionized, so as to deposit and form the P-type doped amorphous silicon layer on the intrinsic amorphous silicon layer.

SiH₄ →Si + 4H⁺ (Equation 3)

H₂ → 2H⁺ (Equation 4)

B₂H₆ → 2B + 3H₂ (Equation 5)

In some embodiment, a temperature in the PECVD process ranges from 200°C to 400°C. Exemplarily, a temperature for forming the P-type doped amorphous silicon layer is 220°C, 240°C, 260°C, 280°C, 300°C, 320°C, 340°C, 360°C or 380°C.

Compared to the TOPCon cell, forming a boron doped polysilicon layer as the P-type doped polysilicon layer on the front side of the cell through a boron diffusion process needs to control the high temperature and high flow conditions, resulting in higher production cost, and higher equipment loss and maintenance cost of the furnace tube. In the present application, the intrinsic amorphous silicon layer and the P-type doped amorphous silicon layer may be deposited and formed at 200°C-400°C through the PECVD process, so that the deposition temperature is low, the equipment loss and maintenance cost are low, and the production cost may be effectively reduced. Moreover, the intrinsic amorphous silicon layer on the rear side of the cell has high passivation characteristics, and the doped amorphous silicon layer has easy doping characteristics, so that the recombination on the rear side of the cell may be reduced, thereby improving the photoelectric conversion efficiency of the solar cell.

In the present application, in operation S405, a first passivation layer 540 is formed on the first surface 511, in which the first passivation layer 540 includes a first passivation sub-layer 541 covering the doped polysilicon layer 530 in the first regions 511a, and a second passivation sub-layer 542 covering the second regions 511b.

As shown in FIG. 5, a first passivation layer 540 is formed on the first surface 511 of the substrate 510. In this case, the tunnel oxide layer 520 and the doped polysilicon layer 530 are formed on the first regions 511a in the first surface 511 of the substrate 510, and the second regions 511b in the first surface 511 of the substrate 510 are exposed. Thus, a portion of the first passivation layer 540 covers a top surface of the doped polysilicon layer 530 arranged on the first regions 511a, and this portion of the first passivation layer is the first passivation sub-layer 541; a portion of the first passivation layer 540 covers the second regions 511b and sidewalls of the patterned tunnel oxide layer 520 and the patterned doped polysilicon layer 530, and this portion of the first polysilicon layer 540 is the second passivation sub-layer 542. The first passivation sub-layer 541 is in contact with the doped polysilicon layer 530, and the second passivation sub-layer 542 is in contact with the second regions 511b in the first surface 511 of the substrate 510 as well as the sidewalls of the tunnel oxide layer 520 and the doped polysilicon layer 530.

In some embodiment, a material of the first passivation layer 540 may include alumina.

In some embodiment, a thickness of the first passivation layer 540 ranges from 3 nm to 5 nm. Exemplarily, the thickness of the first passivation layer 540 is 3 nm, 4 nm or 5 nm.

As shown in FIG. 5, a second passivation layer 570 is formed on the second surface 512 of the substrate 510. In this case, an intrinsic amorphous silicon layer 550 and a doped amorphous silicon layer 560 are formed on the second surface 512 of the substrate 510, and thus, the second passivation layer 570 covers the doped amorphous silicon layer 560, that is, the second passivation layer 570 is in contact with the doped amorphous silicon layer 560.

In some embodiment, a material of the second passivation layer 570 may include alumina.

In some embodiment, a thickness of the second passivation layer 570 ranges from 3 nm to 5 nm. Exemplarily, the thickness of the second passivation layer 570 is 3 nm, 4 nm or 5 nm.

In some embodiments, the process of forming the first passivation layer 540 and the second passivation layer 570 may include an Atomic Layer Deposition (ALD).

As shown in FIG. 5, a first antireflection layer 581 is formed on the first surface 511 of the substrate 510, in which the first antireflection layer 581 covers the first passivation layer 540, that is, the first antireflection layer 581 is in contact with the first passivation sub-layer 541 and the second passivation sub-layer 542, and in this case, the first antireflection layer 581 covers both the first regions 511a and the second regions 511b in the first surface 510. A second antireflection layer 582 is formed on the second surface 512, in which the second antireflection layer 582 covers the second passivation layer 570, that is, the second antireflection layer 582 is in contact with the second passivation layer 570.

In the present application, the first passivation layer and the first antireflection layer are formed on the first surface of the substrate, so that the passivation effect on the first surface of the substrate may be improved. The second passivation layer and the second antireflection layer are formed on the second surface of the substrate, so that the passivation effect on the second surface of the substrate may be improved.

In some embodiments, a material of each of the first antireflection layer 581 and the second antireflection layer 582 may include silicon nitride.

In some embodiments, a thickness of the first antireflection layer 581 ranges from 70 nm to 90 nm. Exemplarily, the thickness of the first antireflection layer 581 is 70 nm, 75 nm, 80 nm, 85 nm or 90 nm.

In some embodiments, a refractive index of the first antireflection layer 581 ranges from 2.1 to 2.2.

In some embodiments, a thickness of the second antireflection layer 582 ranges from 90 nm to 110 nm. Exemplarily, the thickness of the second antireflection layer 582 is 90 nm, 95 nm, 100 nm, 105 nm or 110 nm.

In some embodiments, a refractive index of the second antireflection layer 582 ranges from 2.2 to 2.3.

In the HJT cell, a transparent conductive layer is formed on each of the front side and the rear side of the cell, so as to reduce the series resistance of the cell. However, a material of the transparent conductive layer contains indium element, and the material is basically imported, resulting in higher cost of forming the transparent conductive layer. In the present application, it is not necessary to form the transparent conductive layer on each of the front side and the rear side of the solar cell, so that the manufacturing cost of the solar cell may be reduced.

As shown in FIG. 5, first contact holes are formed, in which the first contact holes penetrate through the first antireflection layer 581 and the first passivation sub-layer 541 and expose the doped polysilicon layer 530, and second contact holes are formed, in which the second contact holes penetrate through the second antireflection layer 582 and the second passivation layer 570 and expose the doped amorphous silicon layer 560. A first electrode 591 is formed in each of the first contact holes, and a second electrode 592 is formed in each of the second contact holes.

Here, the first antireflection layer 581 and the first passivation sub-layer 541 may be perforated by using laser, so as to form the first contact holes. Further, the second antireflection layer 582 and the second passivation layer 570 may be perforated by using laser, so as to form the second contact holes.

In some embodiments, a wavelength of the laser may range from 300 nm to 1100 nm, and a spot size of the laser may range from 50 µm to 100 µm.

Here, screen printing of a front-side metallization pattern may be performed to form the first electrodes 591, and screen printing of a rear-side metallization pattern may be performed to form the second electrodes 592.

In some embodiments, a dimension of the first electrode in the X direction is smaller than or equal to a dimension of the patterned doped polysilicon layer 530 in the X direction.

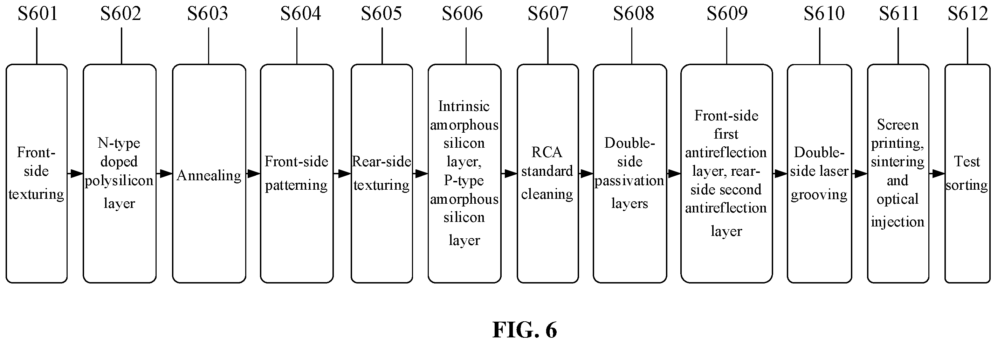

With reference to FIG. 6, FIG. 6 is a flowchart for manufacturing a solar cell according to the present application. As shown in FIG. 6, in operation S601, front-side texturing is performed.

Here, before a film layer structure is formed on the front side of the substrate, the front side of the substrate needs to be cleaned first. For example, the front side of the substrate may be cleaned by using KOH, NaOH, or the like, so as to remove dirt and impurities on the front side. Meanwhile, it is also necessary to form a textured structure (i.e., a pyramid structure) on the front side of the substrate, so as to reduce reflection of incident light, thereby improving the photoelectric conversion efficiency of the solar cell.

In some embodiments, after the front-side texturing operation, a weight of the substrate is reduced by 0.2 g to 0.4 g.

In some embodiments, after the front-side texturing operation, a reflectivity of the front side of the substrate ranges from 8% to 10%, and a size of the textured structure of the front side of the substrate ranges from 1.4 µm to 1.8µm, and a height of the textured structure of the front side of the substrate ranges from 0.8 µm to 1.2 µm.

As shown in FIG. 6, in operation S602, an N-type doped polysilicon layer is formed.

Here, a tunnel oxide layer and an N-type doped polysilicon layer may be formed on the front side of the substrate through a PECVD process or a LPCVD process. Considering that the front side of the substrate has a textured structure, compared to the formation of the tunnel oxide layer and the N-type doped polysilicon layer on the rear side of the substrate in the TOPCon cell, it is necessary to increase the overall ventilation for forming the tunnel oxide layer and the N-type doped polysilicon layer on the front side of the substrate.

In some embodiments, a protective layer may also be formed on the front side of the substrate, in which the protective layer covers the N-type doped polysilicon layer.

As shown in FIG. 6, in operation S603, annealing is performed.

Here, the N-type doped polysilicon layer needs to be annealed. Under the atmosphere containing a small amount of oxygen, crystallization annealing of the N-type doped polysilicon layer is completed to form voids in the tunnel oxide layer, so as to form an effective internal diffusion, and complete the field passivation of the substrate, in which a square resistance after annealing ranges from 25 Ω/sq to 65 Ω/sq.

In some embodiments, a doping concentration of the N-type doped polysilicon layer ranges from 1E+20 N/cm³ to 8E+20 N/cm³.

In some embodiments, a doping depth of the N-type doped polysilicon layer ranges from 40 nm to 110 nm.

As shown in FIG. 6, in operation S604, front-side patterning is performed.

Here, the N-type doped polysilicon layer and the tunnel oxide layer formed on the front side of the substrate may be patterned through processes including, but not limited to, laser processing, etching slurry, a chemical method, or the like, so as to remove the N-type doped polysilicon layer and the tunnel oxide layer in the non-electrode contact region. In the present application, the front-side patterning process is not particularly limited, as long as the tunnel oxide layer and the N-type doped polysilicon layer covering the second regions may be removed, and the tunnel oxide layer and the N-type doped polysilicon layer covering the first regions may be retained.

As shown in FIG. 6, in operation S605, rear-side texturing is performed.

Here, before a film layer structure is formed on the rear side of the substrate, the rear side of the substrate needs to be cleaned first, so as to remove a wrap around layer on the rear side of the substrate and form a textured structure on the rear side of the substrate. For example, the wrap around layer on the rear side of the substrate may be removed by using HF, and the rear side of the substrate can be cleaned by using, for example, KOH, NaOH, or the like, so as to remove dirt and impurities on the rear side, and a textured structure may be formed on the rear side of the substrate.

In some embodiments, after the rear-side texturing operation, a weight of the substrate is reduced by 0.1 g to 0.2 g.

In some embodiments, after the rear-side texturing operation, a reflectivity of the rear side of the substrate ranges from 12% to 14%, and a size of the textured structure of the rear side of the substrate ranges from 2.4 µm to 3.8µm, and a height of the textured structure of the rear side of the substrate ranges from 0.8 µm to 1.2 µm.

As shown in FIG. 6, in operation S606, an intrinsic amorphous silicon layer and a P-type amorphous silicon layer are formed.

Here, a rear-side plate PECVD process may be performed, so as to form an intrinsic amorphous silicon layer and a P-type amorphous silicon layer on the rear side of the substrate.

As shown in FIG. 6, in operation S607, RCA standard cleaning is performed.

Here, PSG formed on the front side and the periphery of the substrate in the previous operation may be removed.

As shown in FIG. 6, in operation S608, double-side passivation layers are formed.

Here, a first passivation layer may be formed on the front side of the substrate, and a second passivation layer may be formed on the rear side of the substrate.

As shown in FIG. 6, in operation S609, a front-side first antireflection layer and a rear-side second antireflection layer are formed.

Here, a first antireflection layer may be formed on the front side of the substrate, and a second antireflection layer may be formed on the rear side of the substrate.

As shown in FIG. 6, in operation S610, double-side laser grooving is performed.

Here, the first antireflection layer and the first passivation layer on the front side of the substrate are perforated by using laser to form first contact holes, and the second antireflection layer and the second passivation layer on the rear side of the substrate are perforated by using laser to form second contact holes.

As shown in FIG. 6, in operation S611, screen printing, sintering and optical injection are performed.

Here, screen printing of a front-side metallization pattern is performed on the front side of the substrate to form first electrodes, and screen printing of a rear-side metallization pattern is performed on the rear side of the substrate to form second electrodes. After low-temperature sintering, light injection is performed, so as to perform passivation of the inside of the solar cell.

As shown in FIG. 6, in operation S612, test sorting is performed.

As shown in FIG. 5, the present application provides a solar cell. The above solar cell 500 includes: a substrate 510, in which the substrate is provided with a first surface 511 and a second surface 512 arranged opposite to the first surface, the first surface 511 including first regions 511a and second regions 511b, the first regions and the second regions being alternately arranged; a tunnel oxide layer 520 and a doped polysilicon layer 530 which are arranged on the first regions 511a in the first surface 511, in which the tunnel oxide layer 520 is arranged between the first surface 511 and the doped polysilicon layer 530; a first passivation layer 540, in which the first passivation layer includes a first passivation sub-layer 541 covering the doped polysilicon layer 530 in the first regions 511a, and a second passivation sub-layer 542 covering the second regions 511b; and an intrinsic amorphous silicon layer 550 and a doped amorphous silicon layer 560 which are arranged on the second surface 512, in which the intrinsic amorphous silicon layer 550 is arranged between the second surface 512 and the doped amorphous silicon layer 560, in which a conductivity type of the doped polysilicon layer 530 is different from a conductivity type of the doped amorphous silicon layer 560.

In some embodiments, the above solar cell 500 further includes: a first antireflection layer 581 covering the first passivation layer 540; and first electrodes 591, in which the first electrodes penetrate through the first antireflection layer 581 and the first passivation sub-layer 541 and are in contact with the doped polysilicon layer 530.

In some embodiments, the above solar cell 500 further includes: a second passivation layer 570 covering the doped amorphous silicon layer 560; a second antireflection layer 582 covering the second passivation layer 570; and second electrodes 592, in which the second electrodes penetrate through the second antireflection layer 582 and the second passivation layer 570 and are in contact with the doped amorphous silicon layer 560.

In some embodiments, the substrate 510 includes an N-type semiconductor substrate, the doped polysilicon layer 530 includes an N-type doped polysilicon layer, and the doped amorphous silicon layer 560 includes a P-type doped amorphous silicon layer.

In some embodiments, a thickness of the tunnel oxide layer 520 ranges from 0.5 nm to 3 nm, and a thickness of the doped polysilicon layer 530 ranges from 60 nm to 130 nm.

In some embodiments, a thickness of the intrinsic amorphous silicon layer 550 ranges from 5 nm to 9 nm, and a thickness of the doped amorphous silicon layer 560 ranges from 30 nm to 40 nm.

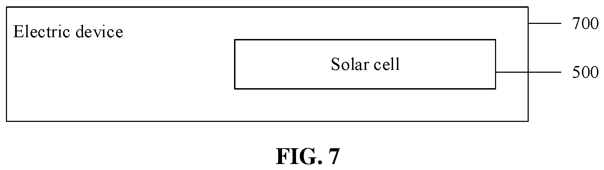

With reference to FIG. 7, FIG. 7 is a schematic view of an electric device according to the present application. As shown in FIG. 7, the present application provides an electric device 700. The above electric device 700 includes the solar cell 500 as described in the above technical solutions.

Here, the solar cell may be used as a power source for the electric device, or may be used as an energy storage unit for the electric device. The electric device may include, but is not limited to, a mobile device (such as, a mobile phone, a notebook computer, etc.), an electric vehicle (such as, a pure electric vehicle, a hybrid electric vehicle, a plug-in hybrid electric vehicle, an electric bicycle, an electric scooter, an electric golf cart, an electric truck, etc.), an electric train, a ship and a satellite, an energy storage system, and the like.

### Embodiments

Hereinafter, embodiments of the present application will be described. The embodiments described below are exemplary and merely used to explain the present application, but they are not constructed as limiting the present application. If specific techniques or conditions are not specified in the embodiments, the embodiments can be carried out according to the techniques or conditions described in the documents in the art or according to the product specification. If the manufacturer of the reagent or instrument used is not specified, the reagent or instrument used is a conventional product that can be commercially obtained.

### Embodiment 1

The operations for preparing the solar cell in the Embodiment 1 are as follows.
1. Texturing is performed, in which dirt and impurities on the surface of the silicon wafer are cleaned and removed by using KOH, so as to complete tissue structuring of the surface on the front side.
2. Deposition of SiO₂-N-Poly on the front side is completed through a PECVD process, in which a thickness of a tunnel oxide layer SiO₂ on the front side is 1.7 nm, a thickness of an N-Poly on the front side is 90 nm, and a thickness of a protective layer on the front side is 5.5 nm.
3. Annealing of a silicon wafer is performed, in which under the nitrogen atmosphere, at a flow rate of 7500 sccm and a temperature of 900°C, crystallization annealing of the N-Poly is completed to form voids in the tunnel oxide layer, so as to form an effective internal diffusion, and complete the field passivation of the substrate, in which a square resistance after annealing is 45 Ω/sq, a doping concentration tested by ECV is 4.5E+20N/cm³, and a doping depth is 75 nm.
4. Patterning of SiO₂-N-Poly on the front side is performed, in which the N-Poly with a width of 70 µm is retained in a gate line contact region to ensure electrode contact, and the N-Poly and the tunnel oxide layer SiO₂ in a non-gate line region are removed to reduce shading loss.
5. Texturing cleaning is performed, in which a wrap around layer on the rear side is removed by using HF, and the wrap on the rear side is etched by using KOH, so as to perform texturing on the rear side, in which a weight is reduced by 0.15 g, a reflectivity is 13%, a size of the texture is 3.2 µm, and a height of the texture is 1.0 µm.
6. A rear-side plate PECVD process is performed, in which a thickness of an intrinsic amorphous silicon layer is 7 nm, and a thickness of a P-type doped amorphous silicon layer is 35 nm.
7. Alumina is deposited on the front side and on the rear side, in which a thickness of the alumina is 4 nm.
8. Silicon nitride is deposited on the front side, in which a thickness of the silicon nitride on the front side is 80 nm, and a refractive index of the silicon nitride on the front side is 2.15.
9. Silicon nitride is deposited on the rear side, in which a thickness of the silicon nitride on the rear side is 100 nm, and a refractive index of the silicon nitride on the rear side is 2.25.
10. Laser grooving is performed on the silicon nitride on each of the front side and rear side and the alumina on each of the front side and rear side, so as to ensure good contact of the electrodes, in which the laser with a wavelength of 650 nm and a spot size of 90 µm is used.
11. Screen printing and drying of a rear-side metallization pattern are performed, and screen printing of a front-side metallization pattern is performed, and then low-temperature sintering and light injection are performed, so as to perform passivation of the inside of the solar cell.
12. Test sorting is performed.

### Contrasting Example 1

The operations for preparing the solar cell in the Contrasting Example 1 are as follows.
1. Texturing is performed, in which damage removal and surface structure preparation are performed on a silicon wafer, in which a weight is reduced by 0.28 g, a reflectivity is 10%, a size of the texture is 1.4 µm, and a height of the texture is 1.1 µm.
2. Boron diffusion is performed, in which BCl₃ is introduced into a tube furnace to complete doping of boron on the substrate, so as to form a PN junction on the front side, in which a square resistance of the front side is 250 Ω/sq, a doping concentration is 5E+18N/cm³, and a depth of the junction is 1.0µm.
3. Alkali polishing is performed, in which BSG at the edge and on the rear side is first removed by using HF, and the edge and the rear side are etched by using KOH, in which a reflectivity of the rear side is maintained at 43%.
4. A tunnel oxide layer SiO₂ and an N-Poly are formed, in which through a PECVD process, N₂O is ionized to form a tunnel oxide layer with a thickness of 1.5 nm on the rear side, SiH₄ and PH₃ are ionized to form an N-Poly with a thickness of 110 nm, and N₂O and SiH₄ are ionized to form a silicon dioxide protective layer with a thickness of 6 nm.
5. Annealing is performed in a nitrogen atmosphere, in which after annealing a square resistance is 30 Ω/sq, a surface concentration is 5E+19N/cm³, and a thickness is 100 nm.
6. RCA cleaning is performed, in which BSG on the front side is removed by using HF, a wrap N-Poly on the front side is removed by using NaOH/KOH, and BSG on the front side and a protective layer on the rear side are removed by using HF.
7. Alumina is formed on the front side, in which a thickness of the alumina is 8 nm.
8. Silicon nitride is formed on the front side, in which a thickness of the silicon nitride on the front side is 78 nm, and a refractive index of the silicon nitride on the front side is 2.1.
9. Silicon nitride is formed on the rear side, in which a thickness of the silicon nitride on the rear side is 88 nm, and a refractive index of the silicon nitride on the rear side is 2.2.
10. Screen printing and sintering are performed.
11. Laser assisted sintering is performed.
12. Test sorting is performed.

### Test Example

Standard Test Conditions (STC) is a general international benchmark for solar cell performance testing. The testing machine is a Halm IV (Cetispv-xf-tube type) testing machine, and the test parameters includes the following aspects:
(1) Light intensity: the solar radiation intensity is 1000 watts/square meter (W/m²), or equivalent to 100 mW/cm².
(2) Temperature: the temperature of the cell is 25°C.
(3) Spectral distribution: the spectral distribution must comply with the AM1.5G standard, which simulates the spectral characteristics of sunlight passing through the atmosphere and reaching the ground.

**Table 1 Test results in Contrasting Example 1 and Embodiment 1**

| | Eta (%) | Uoc (V) | Isc (A) | FF (%) | RserLfDf (Ω) | RshuntDfDr (Ω) |
|---|---|---|---|---|---|---|
| Contrasting Example 1 | 25.66 | 0.7274 | 13.77 | 84.52 | 0.0005 | 3194 |
| Embodiment 1 | 26.97 | 0.7370 | 14.13 | 86.21 | 0.0007 | 3931 |

As shown in Table 1, compared to the TOPCon cell provided in the Contrasting Example 1, the solar cell provided in the Embodiment 1 has a higher photoelectric conversion efficiency (Eta), which is increased by 1.3%. In the Contrasting Example 1, the open circuit voltage (Uoc), the short circuit current (Isc), the filling factor (FF), and the parallel resistance (RshuntDfDr) are all increased, but the series resistance (RserLfDf) has no significant change. The solar cell provided in the present application may be upgraded in the existing TOPCon cell line, so that the equipment procurement cost is low. Further, the process temperature is low, and the equipment loss is small.

It should be understood that "one embodiment" or "an embodiment" mentioned throughout the specification indicates that a particular feature, structure, or characteristic relating to the embodiment is included in at least one embodiment of the present application. Therefore, "in one embodiment" or "in an embodiment" throughout the specification does not necessarily refer to a same embodiment. In addition, these particular features, structures, or characteristics may be combined in one or more embodiments in any appropriate manner. It should be understood that, in the embodiments of the present application, sequence numbers of the foregoing processes do not mean execution sequences. The execution sequences of the processes should be determined according to functions and internal logic of the processes, and should not be construed as any limitation on the implementation processes of the present application. The above-mentioned sequence numbers of the present application are merely for the description, and do not represent the advantages and disadvantages of the embodiments.

The above descriptions are only the preferred implementations of the present application, and are not intended to limit the patent scope of the present application. Any equivalent structural changes made by the contents of the specification and accompanying drawings of the present application within the inventive concept of the present application, or the embodiments directly/indirectly applied to other related technical fields, are included in the patent protection scope of the present application.

## Claims

1. A solar cell (500), **characterized in that** the solar cell comprises:
a substrate (510), wherein the substrate is provided with a first surface (511) and a second surface (512) arranged opposite to the first surface, the first surface (511) comprising first regions (511a) and second regions (511b), the first regions and the second regions being alternately arranged;
a tunnel oxide layer (520) and a doped polysilicon layer (530) which are arranged on the first regions (511a) in the first surface (511), wherein the tunnel oxide layer (520) is arranged between the first surface (511) and the doped polysilicon layer (530);
a first passivation layer (540), wherein the first passivation layer comprises a first passivation sub-layer (541) covering the doped polysilicon layer (530) in the first regions (511a), and a second passivation sub-layer (542) covering the second regions (511b); and
an intrinsic amorphous silicon layer (550) and a doped amorphous silicon layer (560) which are arranged on the second surface (512), wherein the intrinsic amorphous silicon layer (550) is arranged between the second surface (512) and the doped amorphous silicon layer (560), wherein a conductivity type of the doped polysilicon layer (530) is different from a conductivity type of the doped amorphous silicon layer (560).

2. The solar cell (500) according to claim 1, further comprising:
a first antireflection layer (581) covering the first passivation layer (540); and
first electrodes (591), wherein the first electrodes penetrate through the first antireflection layer (581) and the first passivation sub-layer (541) and are in contact with the doped polysilicon layer (530).

3. The solar cell (500) according to claim 1, further comprising:
a second passivation layer (570) covering the doped amorphous silicon layer (560);
a second antireflection layer (582) covering the second passivation layer (570); and
second electrodes (592), wherein the second electrodes penetrate through the second antireflection layer (582) and the second passivation layer (570) and are in contact with the doped amorphous silicon layer (560).

4. The solar cell according to claim 1, wherein the substrate (510) comprises an N-type semiconductor substrate, the doped polysilicon layer (530) comprises an N-type doped polysilicon layer, and the doped amorphous silicon layer (560) comprises a P-type doped amorphous silicon layer.

5. The solar cell according to any one of claims 1, 2 or 4, wherein a thickness of the tunnel oxide layer (520) ranges from 0.5 nm to 3 nm, and a thickness of the doped polysilicon layer (530) ranges from 60 nm to 130 nm.

6. The solar cell according to any one of claims 1, 2 or 4, wherein a thickness of the intrinsic amorphous silicon layer (550) ranges from 5 nm to 9 nm, and a thickness of the doped amorphous silicon layer (560) ranges from 30 nm to 40 nm.

7. A manufacturing method of a solar cell, **characterized in that** the manufacturing method comprises:
providing a substrate (510), wherein the substrate (510) is provided with a first surface (511) and a second surface (512) arranged opposite to the first surface, the first surface (511) comprising first regions (511a) and second regions (511b), the first regions and the second regions being alternately arranged;
sequentially forming a tunnel oxide layer (520) and a doped polysilicon layer (530) on the first surface (511);
patterning the doped polysilicon layer (530) and the tunnel oxide layer (520) to expose the second regions (511b) in the first surface (511);
sequentially forming an intrinsic amorphous silicon layer (550) and a doped amorphous silicon layer (560) on the second surface (512), wherein a conductivity type of the doped polysilicon layer (530) is different from a conductivity type of the doped amorphous silicon layer (560); and
forming a first passivation layer (540) on the first surface (511), wherein the first passivation layer (540) comprises a first passivation sub-layer (541) covering the doped polysilicon layer (530) in the first regions (511a), and a second passivation sub-layer (542) covering the second regions (511b).

8. The manufacturing method according to claim 7, wherein sequentially forming the intrinsic amorphous silicon layer (550) and the doped amorphous silicon layer (560) on the second surface (512) comprises:
introducing and reacting a silicon source gas through a plasma enhanced chemical vapor deposition process to form the intrinsic amorphous silicon layer (550); and
introducing and reacting a silicon source gas and a gas containing doped elements, to form the doped amorphous silicon layer (560).

9. The manufacturing method according to claim 8, wherein a temperature in the plasma enhanced chemical vapor deposition process ranges from 200°C to 400°C.

10. The manufacturing method according to any one of claims 7, 8 or 9, further comprising:
forming a second passivation layer (570) on the second surface (512), wherein the second passivation layer (570) covers the doped amorphous silicon layer (560);
forming a first antireflection layer (581) on the first surface (511), wherein the first antireflection layer (581) covers the first passivation layer (540); and
forming a second antireflection layer (582) on the second surface (512), wherein the second antireflection layer (582) covers the second passivation layer (570).

11. The manufacturing method according to claim 10, further comprising:
forming first electrodes (591), wherein the first electrodes penetrate through the first antireflection layer (581) and the first passivation sub-layer (541) and are in contact with the doped polysilicon layer (530); and
forming second electrodes (592), wherein the second electrodes penetrate through the second antireflection layer (582) and the second passivation layer (570) and are in contact with the doped amorphous silicon layer (560).

12. An electric device (700), comprising the solar cell (500) according to any one of claims 1 to 6.
